# EUROPÄISCHE PATENTANMELDUNG

(11) **EP 2 071 638 A1**
(43) Veröffentlichungstag der Anmeldung: **17.06.2009**
(21) Anmeldenummer: 07834967.7
(22) Anmeldetag: 01.08.2007
(51) Int. Cl.: H01L 33/00

(54) **LICHTEMITTIERENDE HALBLEITER-HETEROSTRUKTUR**

(30) Priorität: 08.08.2006 RU 2006129223
(71) Anmelder: "Svetlana-Optoelektronika", St. Petersburg, 194156 (RU)
(72) Erfinder: ZAKGEIM, Dmitry Aleksandrovich, St.Petersburg, 197371 (RU); ROZHANSKY, Igor Vladimirovich, St.Petersburg, 198005 (RU)
(74) Vertreter: Jeck, Anton
(86) Internationale Anmeldenummer: PCT/RU2007/000441
(87) Internationale Veröffentlichungsnummer: WO 2008/018817

(57) **Zusammenfassung**

Die Erfindung betrifft eine Halbleiter-Leuchtheterostruktur auf der Basis von Mischkristallen der Nitride der dritten Metallgruppe Alₓln_{y}Ga_{1-(x+y)}N (0 = x = 1, 0 = y = 1) mit einem p-n Übergang, die eine Sequenz von Epitaxialschichten aufweist, welche n-und p-leitende Gebiete ausbilden. Dabei ist in einem dieser Gebiete ein aktives Gebiet geformt, welches mindestens eine Quantenmulde enthält. Das andere Gebiet schließt eine Strombegrenzungsschicht ein. Bei dieser Halbleiter-Leuchtheterostruktur ist vorgesehen, dass das aktive Gebiet innerhalb des p-leitenden Gebiets und die Strombegrenzungsschicht im n-leitenden Gebiet angeordnet sind, dann wird der äußere Quantenwirkungsgrad der Halbleiter-Leuchtheterostruktur erhöht.

## Beschreibung

Die Erfindung betrifft eine Halbleiter-Leuchtheterostruktur auf der Basis von Mischkristallen der Nitride der dritten Metallgruppe Alₓln_{y}Ga_{1-(x+y)}N (0 = x = 1, 0 = y = 1) mit einem p-n Übergang, die eine Sequenz von Epitaxialschichten aufweist, welche n-und p-leitende Gebiete ausbilden. Dabei ist in einem dieser Gebiete ein aktives Gebiet geformt, welches mindestens eine Quantenmulde enthält. Das andere Gebiet schließt eine Strombegrenzungsschicht ein.

Darunter sind betroffen lichtemittierende Halbleitergeräte insbesondere Leuchtdioden auf der Basis von Mischkristallen der Nitride der dritten Metallgruppe (solid solutions of nitrides of third group metals).

Es sind Leuchtheterostrukturen auf der Basis von Mischkristallen der Nitride der dritten Metallgruppe AllnGaN mit p-n Übergang (p-n junction) bekannt. Sie enthalten eine Reihenfolge von Epitaxialschichten (sequence of epitaxial layers). Diese Epitaxialschichten bilden ein n-leitendes und ein p-leitendes Gebiet (n- and p-type conductivity region). Dabei wurde im n-leitenden Gebiet das aktive Gebiet (active area) gebildet, welches eine oder mehrere Quantenmulden (quantum well) aufweist. Im p-leitenden Gebiet wurde dagegen eine Breitband-Strombegrenzungsschicht angeordnet. Die Breitband-Strombegrenzungsschicht (wide bandgap current-blockung layer) ist aus Nitridmaterial mit einer p-Legierung (p-doped) ausgeführt (s. z. B., US 6515313, RU 2262155, RU 2277736).

Beim direkten Stromdurchlass werden die Löcher aus der im p-leitenden Gebiet angeordneten Breitband-Strombegrenzungsschicht (aus dem p-Emitter) ins aktive Gebiet injiziert. Hier kommt ihre Strahlungsrekombination mit Elektronen zustande. Die Inversion der Elektroneninjektion ins p-Gebiet ist ein Störvorgang, weil die Rekombination in diesem Gebiet strahlungslos erfolgt. Die im p-Gebiet angeordnete Strombegrenzungsschicht (Barriereschicht, Emitterschicht) ist aus dem p-leitenden Nitridmaterial mit großer Breite des verbotenen Bandes ausgeführt. Diese Strombegrenzungsschicht verhindert die Elektroneneindringung ins p-Gebiet. Das trägt zur Erhöhung des Nutzeffektes der Löcherinjektion (hole injection) und folglich zur Erhöhung des äußeren Quantenwirkungsgrades der Leuchtheterostruktur bei.

Die kennzeichnende Besonderheit der betrachteten Leuchtheterostrukturen auf der Basis von Mischkristallen der Nitride der dritten Metallgruppe AllnGaN ist das Vorhandensein der darin integrierten elektrischen Felder (build-in electric fields) mit einer komplizierten Konfiguration an der Grenze GaN/AlGaN. Die elektrischen Grenzen entstehen infolge des Piezoeffektes und der spontanen Polarisation (spontaneous polarization). Dabei stellt sich heraus, dass die Fähigkeit der Strombegrenzungsschicht, die Elektroneneindringung ins p-Gebiet zu verhindern, wesentlich unterdrückt wird. Um den äußeren Quantenwirkungsgrad (external quantum efficiency) der genannten Strukturen zu erhöhen, müssen spezielle Maßnahmen angewendet werden. Diese Maßnahmen dienen der Zunahme der Energiebarriere (potential barrier) für Elektronen in der Strombegrenzungsschicht und/oder der Zunahme der Löcherkonzentration (hole concentration) und der Effizienzsteigerung der Löcherinjektion. Das wird unter anderem durch die Auswahl der Zusammensetzung der Nitridverbindungen erreicht, die die Strombegrenzungsschicht ausbilden.

Der der Erfindung am nächsten kommende Stand der Technik ist eine Halbleiter-Leuchtheterostruktur aus dem Patent RU 2262155.

Diese Halbleiter-Leuchtheterostruktur auf der Basis von Mischkristallen der Nitride der dritten Metallgruppe AlₓIn_{y}Ga_{1-(x+y)}N (0 = x = 1, 0 = y = 1) mit einem p-n Übergang enthält eine Sequenz von Epitaxialschichten, die n- und p-Gebiete ausbilden. Dabei weist die Heterostruktur in der Richtung des Epitaxialwachstums (epitaxial growth) konsequent eine n-Kontaktschicht und eine Aktivschicht mit einer Quantenmulde sowie eine Breitband-Strombegrenzungsschicht und eine p-Kontaktschicht auf. Die n-Kontaktschicht und die Aktivschicht sind im n-leitenden Gebiet angeordnet. Die Quantenmulde ist aus Nitridmaterial mit der n-Legierung ausgeführt. Die Breitband-Strombegrenzungsschicht (Barriereschicht) und die p-Kontaktschicht sind im p-leitenden Gebiet angeordnet. Die Breitband-Strombegrenzungsschicht ist aus Nitridmaterial AlGaN mit der p-Legierung ausgeführt.

Dank der ausgewählten Materialzusammensetzung und der Breite der Epitaxialschichten in der betrachteten Heterostruktur wird die Löcherkonzentration an der Aktivschichtgrenze erhöht. Das trägt zur Erhöhung des äußeren Quantenwirkungsgrades der Löcherkonzentration bei. In den oben beschriebenen Heterostrukturen auf der Basis von Mischkristallen der Nitride der dritten Metallgruppe AllnGaN befinden sich das Rekombinationsgebiet im N-Gebiet und die Strombegrenzungsschicht im P-Gebiet. Die oben beschriebenen Heterostrukturen sind durch das Vorhandensein von starken integrierten piezoelektrischen Feldern gekennzeichnet. Jedoch geht die Effektivität der Löcherinjektion ins aktive Gebiet bei der Erhöhung der Pumpstromdichte (pumping current) in dieser Heterostruktur wie auch in den oben beschriebenen Heterostrukturen zurück. Folglich sinkt auch der äußere Quantenwirkungsgrad der Heterostruktur.

Es ist Aufgabe der Erfindung, den äußeren Quantenwirkungsgrad der Halbleiter-Leuchtheterostruktur zu erhöhen.

Die gestellte Aufgabe wird durch die Merkmale des Anspruchs 1 gelöst.

Die Halbleiter-Leuchtheterostruktur auf der Basis von Mischkristallen der Nitride der dritten Metallgruppe AlₓIn_{y}Ga_{1-(x+y)}N (0 = x = 1, 0 = y = 1) mit einem p-n Übergang enthält eine Sequenz von Epitaxialschichten, welche die n- und p-leitenden Gebiete ausbilden. In einem dieser Gebiete ist das aktive Gebiet geformt. Das Aktivgebiet enthält mindestens eine Quantenmulde. Das andere Gebiet schließt die Strombegrenzungsschicht ein.

Gemäß der Erfindung ist das aktive Gebiet innerhalb des p-leitenden Gebiets angeordnet. Die Strombegrenzungsschicht befindet sich im n-leitenden Gebiet.

Die Halbleiter-Leuchtheterostruktur in der Richtung ihres Epitaxialwachstums umfasst folgerichtig ein n-leitendes und ein p-leitendes Gebiet. Dabei enthält das n-leitende Gebiet eine nacheinander angeordnete n-leitende Nitridmaterial-Schicht (GaN) und eine Strombegrenzungsschicht. Die n-leitende Nitridmaterial-Schicht (GaN) dient zur Stromausbreitung (current spreading). Die Strombegrenzungsschicht ist aus n-leitendem Nitridmaterial (AlₓGa₁₋ₓN) ausgeführt. Das p-leitende Gebiet enthält eine nacheinander angeordnete Dünnschicht aus p-leitendem Nitridmaterial (GaN), ein Aktivgebiet mit Quantenmulden und eine Kontaktschicht. Die Quantenmulden sind als Schichten des nichtlegierten Nitridmaterials (In_{y}Ga_{1-y}N) ausgeführt. Die Kontaktschicht ist aus p-leitendem Nitridmaterial (GaN) ausgeführt.

Die Halbleiter-Leuchtheterostruktur in der Richtung ihres Epitaxialwachstums umfasst ein nacheinander angeordnetes p-leitendes Gebiet und ein n-leitendes Gebiet.

Dabei umfasst das p-leitende Gebiet eine nacheinander angeordnete p-leitende Nitridmaterial-Schicht (GaN), ein Aktivgebiet mit Quantenmulden und eine dünne p-leitende Nitridmaterial-Schicht (GaN). Dabei ist das Aktivgebiet durch Schichten aus unlegiertem Nitridmaterial ausgebildet (In_{y}Ga_{1-y}N). Das n-leitende Gebiet umfasst eine nacheinander angeordnete Strombegrenzungsschicht aus n-leitendem Nitridmaterial (AlₓGa₁₋ₓN) und eine Kontaktschicht aus n-leitendem Nitridmaterial (GaN). Dabei weist die vor dem Aktivgebiet angeordnete p-leitende Nitridmaterial-Schicht (GaN) in ihrem unteren Teil einen Bereich mit hohem p+ Dotierungsgrad auf. Die Heterostruktur enthält zusätzlich eine Schicht, die vor dem genannten Bereich mit hohem p+ Dotierungsgrad angeordnet und aus Nitridmaterial (GaN) mit hohem n+ Dotierungsgrad ausgeführt ist. Diese Schicht dient zur Stromausbreitung und bildet zusammen mit dem Bereich mit dem hohen p+ Dotierungsgrad den in Sperrrichtung vorgespannten p-n Tunnelübergang (reversely biased tunnel p-n junction) aus.

Das grundsätzliche Unterscheidungsmerkmal der angemeldeten (inversen) zu bereits bekannten Halbleiter-Leuchtheterostrukturen besteht darin, dass das Aktivgebiet ins p-Gebiet versetzt wird. Damit wird erreicht, dass die Intensität der Trägerrekombination im Aktivgebiet nicht durch die Löcherinjektion sondern durch die Elektroneninjektion festgelegt wird. Dabei verhindert die Breitband-Strombegrenzungsschicht das Eindringen von Löchern ins n-Gebiet. Die Berechnungs- und die Experimentalforschungen der Erfinder haben gezeigt, dass die durch die Strombegrenzungsschicht erzeugte Barrierepotentialhöhe für die Löcher in einer solchen inversen Heterostruktur auf der Basis von Mischkristallen der Nitride der dritten Metallgruppe AllnGaN groß genug sein wird, sogar dann, wenn die integrierten elektrischen Felder mit berücksichtigt werden. Der Anteil der Löcher, die ins n-Gebiet eindringen und somit die Effektivität der Elektroneninjektion reduzieren, ist unbedeutend. Somit ist das technische Ergebnis der angemeldeten Erfindung die Erzeugung einer Energiebarriere für die Löcher. In Kombination mit der wirksamen Elektroneninjektion trägt dies zur Erhöhung der Trägerkonzentration im Aktivgebiet bei. Dementsprechend wird der äußere Quantenwirkungsgrad der angemeldeten Heterostruktur erhöht. Dabei lässt ihre Abhängigkeit vom Pumpstrom bei hoher Stromdichte nicht nach.

Im Einzelfall ist bei der angemeldeten Halbleiter-Leuchtheterostruktur die Ausführung mit einem p-n Übergang möglich. Diese Halbleiter-Leuchtheterostruktur enthält in Richtung ihres Epitaxialwachstums folgerichtig zuerst ein n-leitendes Gebiet und danach ein p-leitendes Gebiet. Demzufolge enthält die Heterostruktur im n-leitenden Gebiet eine n-leitende Schicht aus Nitridmaterial (GaN) zwecks Stromausbreitung und eine n-leitende Strombegrenzungsschicht aus Nitridmaterial (AlₓGa₁₋ₓN). Im p-leitenden Gebiet enthält die Heterostruktur folgerichtig eine dünne p-leitende Nitridmaterial-Schicht (GaN), ein Aktivgebiet mit Quantenmulden und eine Kontaktschicht. Die Quantenmulden sind durch Schichten aus unlegiertem Nitridmaterial (In_{y}Ga_{1-y}N) ausgebildet. Die Kontaktschicht ist aus p-leitendem Nitridmaterial (GaN) ausgeführt.

Diese Heterostruktur schließt das Aktivgebiet mit einigen Quantenmulden ein. Deswegen entfällt der größte Anteil der Strahlungsrekombination der Elektronen, die aus dem n-Gebiet ins p-Gebiet injektiert werden, und der Löcher in dieser Heterostruktur auf die untere Mulde (die erste Mulde in Richtung des Epitaxialwachstums der Heterostruktur). Dabei weist die untere Mulde in einem Vielmuldenaktivgebiet die schlechteste verfahrenstechnische Materialqualität auf. Die obere Mulde hat dagegen die besten Materialeigenschaften.

Damit der Hauptteil der Strahlungsrekombination der Elektronen mit den Löchern im Vielmuldenaktivgebiet auf die obere Mulde zukommt (die über die besten verfahrenstechnischen Eigenschaften verfügt), ist es zweckmäßig, die angemeldete Halbleiter-Leuchtheterostruktur mit zwei p-n Übergängen auszuführen.

Eine solche Heterostruktur enthält in Richtung ihres Epitaxialwachstums p- und n-leitenden Gebiete, die einen p-n Übergang ausbilden. Dabei schließt das p-leitende Gebiet nacheinander die angeordnete p-leitende Nitridmaterial-Schicht (GaN), das Aktivgebiet mit den Quantenmulden und die dünne p-leitende Nitridmaterial-Schicht (GaN) ein. Die Quantenmulden sind durch Schichten aus unlegiertem Nitridmaterial ausgebildet (In_{y}Ga_{1-y}N). Das n-leitende Gebiet umfasst nacheinander die angeordnete Strombegrenzungsschicht aus n-leitendem Nitridmaterial (AlₓGa₁₋ₓN) und eine Kontaktschicht aus n-leitendem Nitridmaterial (GaN). Vor dem Aktivgebiet ist eine p-leitende Nitridmaterial-Schicht (GaN) angeordnet. In ihrem unteren Teil enthält diese Schicht einen Bereich mit hohem p+ Dotierungsgrad. Dabei enthält die Heterostruktur auch eine Schicht, die für die Stromausbreitung vorgesehen ist und aus Nitridmaterial (GaN) mit hohem n+ Dotierungsgrad ausgeführt ist. Diese Schicht liegt vor dem Gebiet mit dem hohen p+ Dotierungsgrad und bildet mit diesem Gebiet einen in Sperrrichtung vorgespannten p-n Tunnelübergang aus.

Die Erfindung wird anhand von Ausführungsbeispielen in den beigefügten Zeichnungen näher erläutert. Es zeigen:
- Fig. 1: die schematische Darstellung der angemeldeten Heterostruktur mit einem p-n Übergang und
- Fig. 2: das Schema der angemeldeten Heterostruktur mit zwei p-n Übergängen.

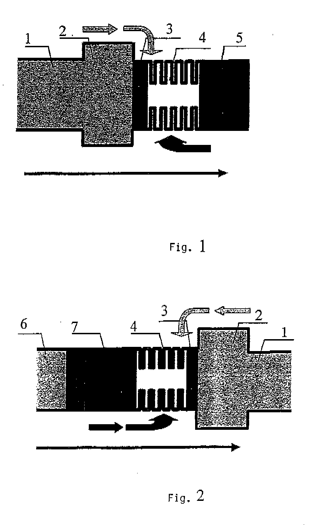

Die Halbleiter-Leuchtheterostruktur gemäß Fig. 1 enthält in der Richtung ihres Epitaxialwachstums folgerichtig:
1 eine dicke (3 - 4 µm) Schicht 1; diese Schicht ist aus einem n-leitenden Nitridmaterial (GaN) ausgeführt und dient zur Stromausbreitung;
2 eine Breitband-Strombegrenzungsschicht 2, die aus einem n-leitenden Nitridmaterial (AlₓGa₁₋ₓN) ausgeführt ist;
3 eine dünne (0,01 - 0,03 µm) Schicht 3, die aus einem p-leitenden Nitridmaterial (GaN) ausgeführt ist;
4 ein Aktivgebiet 4 mit fünf Quantenmulden; die Quantenmulden sind durch Schichten aus unlegiertem Nitridmaterial ausgebildet (In_{y}Ga_{1-y}N) und
5 eine Schicht 5 (mit einer Stärke von 0,1 - 0,3 µm), die aus einem p-leitenden Nitridmaterial (GaN) ausgeführt ist (Kontaktschicht).

In dieser Heterostruktur bilden die Schichten 1 und 2 ein n-leitendes Gebiet und die Schicht 3, das Gebiet 4 und die Schicht 5 ein p-leitendes Gebiet.

Die Halbleiter-Leuchtheterostruktur gemäß Fig. 2 umfasst in der Richtung ihres Epitaxialwachstums folgerichtig:
1 eine dicke (3 - 4 µm) Schicht 6, die aus einem n-leitenden Nitridmaterial (GaN) ausgeführt ist und zur Stromausbreitung dient. Diese Schicht 6 weist ein Gebiet mit hohem n+ Dotierungsgrad auf;
2 eine Schicht 7 (0,05 - 0,1 µm dick), die aus einem p-leitenden Nitridmaterial (GaN) ausgeführt ist. Im unteren Teil dieser Schicht 7 ist ein Bereich mit hohem p+ Dotierungsgrad ausgebildet;
3 ein Aktivgebiet 4 mit fünf Quantenmulden; die Quantenmulden sind durch Schichten aus einem unlegierten Nitridmaterial ausgebildet (In_{y}Ga_{1-y}N);
4 eine dünne (0,01 - 0,03 µm) Schicht 3, die aus einem p-leitenden Nitridmaterial (GaN) ausgeführt ist;
5 eine Breitband-Strombegrenzungsschicht 2, die aus einem n-leitenden Nitridmaterial (AlₓGa₁₋ₓN) besteht und
6 eine Schicht 1, die aus einem n-leitenden Nitridmaterial (GaN) ausgeführt ist (Kontaktschicht).

Die oberen Pfeile in Fig. 1 und 2 kennzeichnen die Elektroneninjektion ins aktive Gebiet. Die unteren Pfeile zeigen die Löcherinjektion ins aktive Gebiet. Der Pfeil unter Fig. 1 und Fig.2 bezeichnet die Richtung des Epitaxialwachstums der Heterostruktur.

Die angemeldete Heterostruktur, deren einzelne Ausführungsbeispiele in Fig. 1 und 2 abgebildet sind, kann nach dem Verfahren der Gasphasenepitaxie aus Organometallverbindungen auf einer Isolierunterlage erzeugt werden. Die Isolierunterlage kann unter anderem aus Saphir ausgeführt werden.

Die Funktionsweise der Halbleiter-Leuchtheterostruktur ist wie folgt:
Wenn der Strom direkt durchgelassen wird, werden die Elektronen aus dem n-leitenden Gebiet ins aktive Gebiet 4 injiziert. Das aktive Gebiet 4 liegt innerhalb des p-leitenden Gebiets. Die Löcher aus dem p-leitenden Gebiet dringen auch in das genannte Aktivgebiet 4 ein. Dabei verhindert die im n-leitenden Gebiet angeordnete Strombegrenzungsschicht 2 das Eindringen von Löchern aus dem p-Gebiet ins n-leitende Gebiet. Die sich einander entgegen bewegenden Elektronen-Löcher-Träger rekombinieren im Aktivgebiet 4. Dabei geben sie ihre Energie an die Lichtquanten weiter.

Die Trägerrekombination erfolgt in den Quantenmulden des Aktivgebiets 4. Die Materialbreite dieser Quantenmulden ist mit der Breite des verbotenen Energiebandes identisch und ist kleiner als die Breite des üblichen Materials des Aktivgebiets 4.

In der Heterostruktur aus Fig. 1 entfällt der Hauptanteil der Strahlungsrekombination der Träger auf die untere Mulde in Richtung ihres Epitaxialwachstums (diese Mulde liegt der Unterlage am Nächsten, auf welcher die Heterostruktur gezüchtet wird). Die untere Mulde weist jedoch die schlechteste verfahrenstechnische Qualität des Materials auf.

In Fig. 2 ist die Heterostruktur mit zwei p-n-Übergängen abgebildet. Hier erfolgt die Strahlungsrekombination im Aktivgebiet 4 des oberen p-n-Übergangs. Dabei kommt der Hauptanteil der Trägerrekombination in der oberen Mulde (in Richtung des Epitaxialwachstums der Heterostruktur) zustande. Die obere Mulde weist in der Regel die beste verfahrenstechnische Materialqualität auf.

Dank den obigen Eigenschaften verfügt die genannte Heterostruktur über die besten Lichtemissionskenndaten. Dabei ist zu bemerken, dass (infolge der Vorspannung des unteren p-n Übergangs in Sperrrichtung im Betriebszustand der Heterostruktur) dieser p-n Übergang tunneltransparent sein muss. Aus diesem Grund ist er durch die Grund ist er durch die hochdotierten n+ und p+ Gebiete ausgebildet, welche im unteren Teil der Heterostruktur jeweils in den Schichten 6 und 7 angeordnet sind.

Die angemeldeten Halbleiter-Leuchtheterostrukturen können als lichtemittierende Elemente in Haushalts- und Industriegeräten eingesetzt werden und in verschiedenen Bereichen Anwendung finden.

Die vorgeschlagenen Halbleiter-Leuchtheterostrukturen wurden im Labor für Halbleiter- und Quantenphysik des loffes Physikalisch-technischen Instituts (Fizikotexnicheskijinstitut im. A. F.loffe) der Russischen Akademie für Wissenschaften geprüft und zeigten einen verhältnismäßig hohen äußeren Quantenwirkungsgrad. Dabei zeigten die Versuche einen unveränderten äußeren Quantenwirkungsgrad bei steigendem Pumpstrom.

## Patentansprüche

1. Halbleiter-Leuchtheterostruktur auf der Basis von Mischkristallen der Nitride der dritten Metallgruppe AlₓIn_{y}Ga_{1-(x+y)}N (0 = x = 1, 0 = y = 1) mit einem p-n Übergang, die eine Sequenz von Epitaxialschichten aufweist, welche n- und p-leitende Gebiete ausbilden, wobei in einem dieser Gebiete ein aktives Gebiet (4) geformt ist, welches mindestens eine Quantenmulde enthält und das andere Gebiet eine Strombegrenzungsschicht (2) einschließt,
**dadurch gekennzeichnet,**
**dass** das aktive Gebiet (4) innerhalb des p-leitenden Gebiets und die Strombegrenzungsschicht (2) im n-leitenden Gebiet angeordnet sind.

2. Halbleiter-Leuchtheterostruktur nach Anspruch 1,
**dadurch gekennzeichnet,**
**dass** diese Heterostruktur in Richtung ihres Epitaxialwachstums nacheinander ein n-leitendes Gebiet und ein p-leitendes Gebiet aufweist, wobei das n-leitende Gebiet eine konsequent angeordnete n-leitende Schicht (1) aus Nitridmaterial (GaN), die zur Stromausbreitung dient, und eine n-leitende Strombegrenzungsschicht (2) aus Nitridmaterial (AlₓGa₁₋ₓN) aufweisen und wobei das p-leitende Gebiet nacheinander eine Dünnschicht (3) aus p-leitendem Nitridmaterial (GaN), ein Aktivgebiet (4) mit Quantenmulden, welche als Schichten eines unlegierten Nitridmaterials (In_{y}Ga_{1-y}N) ausgeführt sind, und eine Kontaktschicht (5) aus p-leitendem Nitridmaterial (GaN) aufweist.

3. Halbleiter-Leuchtheterostruktur nach Anspruch 1,
**dadurch gekennzeichnet,**
**dass** diese Heterostruktur in Richtung ihres Epitaxialwachstums nacheinander ein p-leitendes Gebiet und ein n-leitendes Gebiet aufweist,
**dass** das p-leitende Gebiet nacheinander eine Schicht (7) aus p-leitendem Nitridmaterial (GaN), ein Aktivgebiet (4) mit Quantenmulden, die aus Schichten eines unlegierten Nitridmaterials (In_{y}Ga_{1-y}N) ausgeführt sind, und eine Dünnschicht (3) aus p-leitendem Nitridmaterial (GaN) und ein n-leitendes Gebiet umfasst,
**dass** die nacheinander angeordnete Strombegrenzungsschicht (2) aus einem n-leitenden Nitridmaterial (AlₓGa₁₋ₓN) und einer Kontaktschicht (1) aus n-leitendem Nitridmaterial (GaN) besteht,
**dass** die vor dem Aktivgebiet angeordnete p-leitende Nitridmaterial-Schicht (GaN) in ihrem unteren Teil einen Bereich mit hohem p+ Dotierungsgrad aufweist,
**dass** die Heterostruktur zusätzlich eine Schicht (6) aufweist, die vor dem genannten Bereich mit hohem p+ Dotierungsgrad angeordnet und aus einem Nitridmaterial (GaN) mit hohem n+ Dotierungsgrad ausgeführt ist und
**dass** diese Schicht (6) zur Stromausbreitung dient und zusammen mit dem Bereich mit hohem p+ Dotierungsgrad den in Sperrrichtung vorgespannten p-n Tunnelübergang ausbildet.
